(19) **Europäisches Patentamt / European Patent Office / Office européen des brevets**

(11) **EP 3 186 866 B1**

(12) **EUROPÄISCHE PATENTSCHRIFT**

(45) Veröffentlichungstag und Bekanntmachung des Hinweises auf die Patenterteilung:
**19.11.2025 Patentblatt 2025/47**

(21) Anmeldenummer: **15753028.8**

(22) Anmeldetag: **19.08.2015**

(51) Internationale Patentklassifikation (IPC):
**H02H 9/00** (2006.01)    **G08C 19/02** (2006.01)
**H04Q 9/00** (2006.01)    **G01F 1/66** (2022.01)
**G01F 23/296** (2022.01)

(52) Gemeinsame Patentklassifikation (CPC):
**H02H 9/008; G08C 19/02; H04Q 9/00;** G01F 1/66;
G01F 23/296; H04Q 2209/886

(86) Internationale Anmeldenummer:
**PCT/EP2015/069044**

(87) Internationale Veröffentlichungsnummer:
**WO 2016/030251 (03.03.2016 Gazette 2016/09)**

(54) **EXPLOSIONSSCHUTZSCHALTUNG MIT IMPEDANZANPASSUNG**

EXPLOSION PROTECTION CIRCUIT WITH IMPEDANCE MATCHING

CIRCUIT DE PROTECTION CONTRE LES EXPLOSIONS AVEC ADAPTATION D'IMPÉDANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.08.2014 DE 102014112452**

(43) Veröffentlichungstag der Anmeldung:
**05.07.2017 Patentblatt 2017/27**

(73) Patentinhaber: **Endress+Hauser Flowtec AG**
**4153 Reinach (CH)**

(72) Erfinder:
• **WIEST, Achim**
  **79576 Weil am Rhein (DE)**
• **BERGER, Andreas**
  **79686 Hasel-Glashütten (DE)**
• **BRUMBERG, Oliver**
  **79618 Rheinfelden (DE)**

(74) Vertreter: **Endress + Hauser Group Services (Deutschland) AG+Co. KG**
**Colmarer Straße 6**
**79576 Weil am Rhein (DE)**

(56) Entgegenhaltungen:
EP-A1- 0 817 149    DE-A1- 2 538 911
US-A- 4 708 022    US-B2- 6 885 949

**Beschreibung**

Die Erfindung betrifft eine Vorrichtung zur Überwachung mindestens einer physikalischen oder chemischen Prozessgröße umfassend mindestens eine Sensoreinheit und eine Elektronikeinheit zur Signalerfassung, -auswertung und/oder -speisung, wobei die Vorrichtung geeignet für den Einsatz in explosionsgefährdeten Bereichen ist.

Um ein Feldgerät in einer explosionsfähigen Atmosphäre zu betreiben sind verschiedene Maßnahmen notwendig. Diese haben das Ziel, eine Funkenbildung, die ggf. eine Explosion auslösen könnte, zu vermeiden oder zu verhindern, dass ein im Inneren eines abgeschlossenen Raumes entstehender Funke Auswirkungen auf die Umgebung hat. In dieser Hinsicht werden verschiedene Schutzbereiche unterschieden, und entsprechend gibt es verschiedene Normen für unterschiedliche Umgebungsbedingungen und Anwendungen. Die Norm DIN EN60079-11 definiert die notwendigen Sicherheitsanforderungen für einen Geräteschutz durch Eigensicherheit, bekannt unter der Abkürzung Ex-i. Hierbei handelt es sich um eine Zündschutzart, die auf der Begrenzung von elektrischer Energie innerhalb von Geräten und/oder Verbindungsleitungen, die einer möglicherweise explosionsfähigen Atmosphäre ausgesetzt sind, auf ein Niveau unterhalb dessen beruht, bei dem eine Zündung entweder durch Funkenbildung oder Erwärmung hervorgerufen werden kann. Darüber hinaus können innerhalb dieser Schutzklasse noch verschiedene Schutzniveaus unterschieden werden, Ex-ia, Ex-ib und Ex-ic. Diese Zusätze definieren die vorliegende Ausfallsicherheit der einzelnen Bauelemente und Verbindungsleitungen.

Für einen Explosionsschutz gemäß der Klasse Ex-i muss insbesondere gewährleistet sein, dass die elektrischen Größen Strom, Spannung und Leistung in einem Gerät zu jeder Zeit jeweils unterhalb eines vorgegebenen Grenzwertes liegen. Diese Grenzwerte sind dann so gewählt, dass im Fehlerfall, z. B. durch einen Kurzschluss, die maximal entstehende Wärme nicht ausreicht, um einen Zündfunken zu erzeugen. Dazu wird der Strom häufig durch Widerstände, die Spannung durch Dioden, insb. Zener-Dioden, und die Leistung durch eine geeignete Kombination von strom- und spannungsbegrenzenden Bauelementen unterhalb der vorgegebenen Grenzwerte gehalten. Eine solche Schutzschaltung kann beispielsweise unter der Bezeichnung MCR-PLUGTRAB PT von der Firma Phoenix Contact als steckbare Vorrichtung bezogen werden. In Bezug auf Feldgeräte sind weiterhin mehrere Beispiele bekannt geworden, bei denen die Anforderungen für Explosionsschutz durch spezielle Schaltungsanordnungen erfüllt werden, beispielsweise in der EP0882955A1, DE29809853U1 oder WO2004/098014A1. Letztere Schrift beschreibt insbesondere für die Einheiten zur Strom- und Spannungsbegrenzung Anordnungen von Vorwiderständen vor, während die DE29809853U1 die Verwendung von Zener-Dioden vorsieht. Die Verwendung von Dioden hat jedoch den Nachteil, dass die Anwendungen auf einen bestimmten Temperaturbereich begrenzt sind.

Die US4708022A1 beschreibt eine Anschlussstelle für eine Durchflussüberwachungsbaugruppe mit einem Signalgenerator und einem Signalempfänger.

Die EP0817149A1 beschreibt eine Schaltung zur Übertragung eines Messstroms von einem intrinsisch sicheren Sensor zu einer nicht intrinsisch sicheren Umgebung.

Weiterhin weisen die oben genannten Beispiele für Explosionsschutzschaltungen keine Impedanzanpassung auf. Dies betrifft insbesondere Feldgeräte, bei welchen die Kommunikation zwischen Elektronikeinheit und Sensorelement mittels Wechselstrom oder Wechselspannung erfolgt. Typische Frequenzen liegen im Bereich von 10kHz bis 50MHz. Das Problem besteht darin, dass die Lastimpedanz des Sensorelements oft nicht an die Leitung bzw. Elektronikeinheit angepasst ist, was zu stehenden Wellen auf der Leitung führt. Dadurch kann nicht die vollständige Leistung übertragen werden. Beispielhaft seien hier solche Feldgeräte angeführt, bei welchen das Sensorelement über mindestens ein Piezoelement beaufschlagt wird. Dies betrifft unter anderem Ultraschall-Durchflussmessgeräte oder vibronische Füllstandsmessgeräte, wie sie von der Anmelderin in großer Vielfalt vertrieben werden, im ersten Fall unter der Bezeichnung Prosonic DDU10, Prosonic Proline P, oder Prosonic Flow und im zweiten Fall unter der Bezeichnung Solifant und Liquifant.

Eine typische Methode, um eine Impedanzanpassung, insbesondere an ein Piezoelement, zu gewährleisten besteht in der Verwendung von Spulen oder Transformatoren. Die jeweiligen Bauteile müssen von ihren Charakteristiken her an die Leitung, an die Elektronikeinheit, welche in diesem Falle üblicherweise einen Verstärker aufweist, und an das Piezoelement selbst angepasst werden.

Der vorliegenden Erfindung liegt die Aufgabe zugrunde, ein Feldgerät bereitzustellen mit einer Explosionsschutzschaltung, welche das Betreiben des Feldgeräts in explosionsfähiger Atmosphäre bei gleichzeitiger Übertragung der Signale mit minimalem Leistungsverlust ermöglicht.

Diese Aufgabe wird erfindungsgemäß gelöst durch eine Vorrichtung zur Überwachung mindestens einer physikalischen oder chemischen Prozessgröße umfassend mindestens eine Sensoreinheit und eine Elektronikeinheit zur Signalerfassung, -auswertung und/oder -speisung, wobei die Sensoreinheit mit Wechselstrom betrieben ist und/oder die Kommunikation zwischen der Sensoreinheit und der Elektronikeinheit mit Wechselstrom und/oder Wechselspannung erfolgt, und mit einer Explosionsschutzschaltung mit Eigensicherheit, welche eine Sicherheitsbarriere mit je mindestens einer Einheit zur Strom- und/oder Spannungsbegrenzung umfasst, wobei innerhalb der Explosionsschutzschaltung eine Einheit eingerichtet zur Impedanzanpassung eingerichtet zur verlustfreien Signalübertragung zwischen Sensoreinheit und Elektronikeinheit vorgesehen ist, vorgesehen ist, welche Einheit zur Impedanzanpassung zumindest einen Transformator zur galvanischen Trennung von Sensoreinheit und Elektronikeinheit umfasst,

wobei die Explosionsschutzschaltung zumindest eine einfache Ausfallsicherheit aufweist,
wobei eine Anzahl paralleler Zweige innerhalb der Explosionsschutzschaltung (3) die Ausfallsicherheit bestimmt, wobei eine einfache Ausfallsicherheit durch zwei parallele Zweige gegeben ist,
wobei die Explosionsschutzschaltung über mindestens zwei parallele Zweige verfügt,
wobei die Einheit zur Spannungsbegrenzung zumindest eine Spule umfasst, wobei die Einheit zur Strombegrenzung zumindest einen zur Spule in Reihe geschalteten Widerstand aufweist.

Die Impedanzanpassung gewährt hierbei eine möglichst verlustfreie Übertragung der Signale und entsprechend, dass mehr Energie für die Sensoreinheit zur Verfügung steht, da eine universelle Anpassung über ein großes Intervall zwischen den Impedanzen der Sensoreinheit und der Elektronikeinheit möglich ist.

Eine entsprechende Ausgestaltung des Transformators sorgt zudem für eine Zonentrennung. Dies ist insbesondere für medienberührende Sensoreinheiten mit einem Gehäuse aus Metall und einem Kathodenschutz an einer das Medium führenden Rohrleitung von Vorteil. Der Kathodenschutz bedeutet in einer solchen Anwendung, dass das Potential der Rohrleitung gegenüber der Masseanbindung mittels einer Spannungsquelle auf einem bestimmten Wert, insbesondere zum Beispiel U=5V gehalten wird, um einer Korrosion der Rohrleitung vorzubeugen. Durch die Verwendung einer Explosionsschutzschaltung mit einer galvanischen Trennung zwischen Sensoreinheit und Elektronikeinheit wird in diesem Fall ein unabhängiger Betrieb der Schaltungen ermöglicht. Dies ist bei herkömmlichen Explosionsschutzschaltungen oftmals nicht der Fall.

Dafür ist es von Vorteil, wenn der Transformator so ausgestaltet ist, insbesondere durch die Gewährleistung ausreichend großer Abstände und geeigneter Materialwahl wie Lacke und Isolationsfolien, dass er die galvanische Trennung gewährleistet.

Eine derartige Wahl der spannungsbegrenzenden Bauteile erlaubt die Verwendung der erfindungsgemäßen Vorrichtung in einem weiten Temperaturbereich, insbesondere ist der mögliche Temperaturbereich größer als bei der Verwendung von Dioden.

Dabei ist es ferner von Vorteil, wenn jeweils gleiche Bauteile in den Einheiten zu Strombegrenzung, Spannungsbegrenzung und Impedanzanpassung derart ausgelegt sind, dass sie eine Doppelfunktion aufweisen. Somit können auf beispielsweise die Einheit zur Spannungsbegrenzung und die Einheit zur Impedanzanpassung über den Transformator kombiniert werden. Ferner können die Gleichstromwiderstände der Wicklungen der Spulen ebenfalls strombegrenzend wirken.

In einer anderen bevorzugten Ausgestaltung weist die Sensoreinheit zumindest ein Piezoelement auf. Dies ist insbesondere bei der Anwendung der erfindungsgemäßen Vorrichtung für Ultraschall-Durchflussmessgeräte oder für vibronische Füllstandsmessgeräte der Fall. Die mindestens eine Prozessgröße ist dann beispielsweise gegeben durch den Durchfluss eines Mediums durch ein Rohr, den Füllstand eines Mediums in einem Behälter oder durch die Dichte oder Viskosität des jeweiligen Mediums.

Es ist weiterhin von Vorteil, wenn die Explosionsschutzschaltung zwischen der Sensoreinheit und der Elektronikeinheit fest angeordnet ist. Alternativ kann die Explosionsschutzschaltung auch in einem separaten Steckadapter angeordnet sein, welcher Steckadapter nachrüstbar zwischen der Sensoreinheit und Elektronikeinheit befestigt ist. In diesem Fall können bereits bestehende Geräte nachträglich mit einer Explosionsschutzschaltung und/oder Impedanzanpassung nachgerüstet werden.

Die Anzahl der parallelen Zweige bestimmt die Ausfallsicherheit, es besteht mindestens eine einfache Ausfallsicherheit, wenn die Explosionsschutzschaltung über mindestens zwei parallele Zweige verfügt, und es besteht mindestens eine doppelte Ausfallsicherheit bei mindestens drei parallelen Zweigen. Dies entspricht der Norm Ex-ib. Bei einer doppelten Ausfallsicherheit, welche im Falle von drei parallelen Zweigen erreicht wird, ist sogar die Norm Ex-ia erfüllt.

Dabei ist es von Vorteil, wenn mindestens ein Bauteil, welches innerhalb der Einheiten zur Strom- und/oder Spannungsbegrenzung vorgesehen ist, mehrfach ausgeführt ist. Dies betrifft insbesondere den Fall mit zwei parallelen Zweigen innerhalb der Explosionsschutzschaltung, da die beiden Zweige dann äquivalent ausgestaltet sind. Bei einer einfachen Ausfallsicherheit wären zum Beispiel zwei strombegrenzende Widerstände und zwei spannungsbegrenzende Spulen redundant ausgeführt, während bei einer doppelten Ausfallsicherheit jeweils drei Spulen und drei Widerstände redundant ausgeführt wären.

Ein weiterer Vorteil einer nicht beanspruchten Ausführungsform ergibt sich, wenn mindestens eines der Bauteil ausfallsicher ausgelegt ist. Dies kann beispielsweise erreicht werden durch Spulen mit einer Drahtstärke von Ø > 0.05mm und einer minimalen Durchschlagspannung laut IEC vom Grad 2, durch Widerstände, welche als Drahtwiderstände ausgelegt sind und welche eine ausreichende Temperaturfestigkeit aufweisen, und/oder durch Leiterbahnen mit entsprechendem Querschnitt, insbesondere Höhe und Breite.

In einer anderen besonders bevorzugten Ausgestaltung weist die Explosionsschutzschaltung eine Schaltfunktion auf. Mit dieser Schaltfunktion kann mindestens eine Einheit zur Gewährleistung der Eigensicherheit, insbesondere die Einheit zur Strombegrenzung, überbrückt, insbesondere kurzgeschlossen werden. So kann im Nicht-Ex-Bereich der Transformator ohne eine Strombegrenzung verwendet werden, während im Ex-Bereich eine Variante mit Strombegrenzung und Zonen-Trennung vorgesehen ist.

Dabei ist es insbesondere von Vorteil, wenn die Schaltfunktion nur mit speziellem Werkzeug, insbesondere mit einem Schlüsselschalter, geändert werden kann, oder wenn sie sich in einem Bereich der Vorrichtung befindet, welcher nur mittels speziellen Werkzeugs zugänglich wird.

Ein weiterer Vorteil einer nicht beanspruchten Ausführungsform ergibt sich, wenn die Bereiche der Vorrichtung, welche möglicherweise einer explosionsfähigen Atmosphäre ausgesetzt sind, vergießbar sind und/oder vergossen sind.

Es ist ferner von Vorteil, wenn zwischen der Explosionsschutzschaltung und mindestens einer weiteren Komponente der Vorrichtung mindestens eine Verbindung besteht, und wenn jede Verbindung nur durch Werkzeug lösbar ist, oder unlösbar ist.

Die Erfindung wird nachfolgend anhand von mehreren Ausführungsbeispielen mittels der beiliegenden Figuren näher beschrieben:
Es zeigt:

Fig. 1 ein Blockdiagramm eines Feldgeräts gemäß dem Stand der Technik

Fig. 2 ein Schaltbild einer erfindungsgemäßen Explosionsschutzschaltung mit einfacher Ausfallsicherheit

Fig. 3 ein Schaltbild einer erfindungsgemäßen Explosionsschutzschaltung mit einer erfindungsgemäßen Schaltfunktion.

Fig. 4 ein Schaltbild einer erfindungsgemäßen Explosionsschutzschaltung mit doppelter Ausfallsicherheit

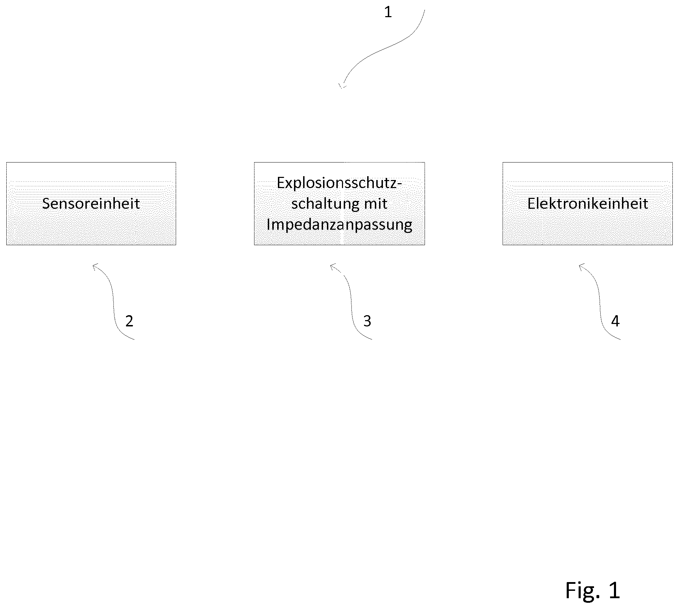

Fig. 1 zeigt ein vereinfachtes Blockschaltbild einer Vorrichtung 1 gemäß Stand der Technik, wie beispielsweise ein Feldgerät. Das Feldgerät kann beispielsweise gegeben sein durch ein nach dem Ultraschallprinzip arbeitendes Durchflussmessgerät. Solche Feldgeräte werden von der Anmelderin in großer Vielfalt hergestellt und beispielsweise unter der Bezeichnung Prosonic DDU10 oder Prosonic Proline P vertrieben. Es versteht sich jedoch von selbst, dass auch andere Typen von Feldgeräten unter die Erfindung fallen. Angedeutet sind die Sensoreinheit 2 und die Elektronikeinheit 4, zwischen welchen eine erfindungsgemäße Explosionsschutzschaltung 3 integriert ist. Diese kann entweder fest angeordnet sein, oder in einem separaten Steckadapter, welche lösbar zwischen der Elektronikeinheit 3 und der Sensoreinheit 2 angebracht ist.

Für die Explosionsschutzschaltung sind verschiedene Varianten möglich, von welchen im Folgenden drei verschiedene Beispiele im Detail gezeigt werden sollen. Es versteht sich von selbst, dass noch viele weitere Anordnungen denkbar sind, welche auch unter die Erfindung fallen.

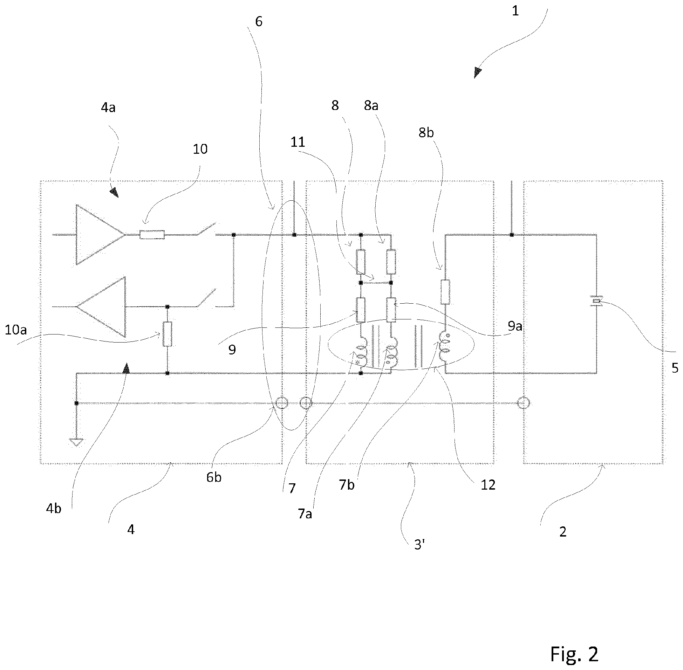

Fig. 2 zeigt ein Schaltbild einer erfindungsgemäßen Explosionsschutzschaltung 3' mit einfacher Ausfallsicherheit, welche zwischen der Elektronikeinheit 4 und der Sensoreinheit 2 angeordnet ist. Die Sensoreinheit 2 umfasst ein Piezoelement 5, welches sich innerhalb einer metallischen Abschirmung befindet und an welches die Impedanz angepasst wird. Die signalführenden Leitungen sind durch Triaxialkabel 6 gegeben, von welchem ein Leiter jeweils mit dem metallischen Gehäuse verbunden 6b ist. Zur Impedanzanpassung wird ein Transformator 12 mit mindestens drei Wicklungen verwendet. In der Regel werden Transformatoren mit zwei Wicklungen ausgeführt. Die dritte Wicklung dient hier entsprechend nicht der Impedanzanpassung, sondern dem Explosionsschutz. Somit kommt dem Transformator 12 im gezeigten Ausführungsbeispiel eine Doppelfunktion zu. Neben der mindestens einen zusätzlichen Wicklung ist es von Vorteil, wenn der Wicklungssinn auf der Seite mit dem Piezoelement 5 entgegen der dem auf der Seite zu der Elektronikeinheit 4 hin ist. Dies wirkt im Fehlerfall reduzierend für die gespeicherte Energie.

Die folgenden Beschreibungen beziehen sich ausschließlich auf die Explosionsschutzschaltung 3'. Die beiden Schaltungszweige auf der linken Seite weisen je eine Spule 7,7a mit je einem Leitungswiderstand 9,9a und je einen in Reihe geschalteten Widerstand zur Strombegrenzung 8,8a auf. Dieser redundante Aufbau sorgt für eine einfache Ausfallsicherung der Explosionsschutzschaltung 3'. In einem dritten Schaltungszweig auf der Seite mit dem Piezoelement 5 finden sich eine weitere Spule 7b und der zugehörige Leitungswiderstand 8b. Durch geeignete Wahl der Induktivitäten und mechanischen Ausführung der Spulen 7,7a,7b kann sowohl die Leistung geeignet transformiert werden, als auch eine Zonentrennung gewährleistet werden. Die Widerstände 8,8a wiederum dienen der Strombegrenzung. Wählt man zu niederohmige Widerstände, so ist der Strom nicht ausreichend begrenzt und die Schaltung gewährleistet lediglich eine Impedanzanpassung. Wird die Vorrichtung in einer nicht explosionsgefährdeten Umgebung betrieben, ist eine solche Wahl von Widerständen 8,8a von Vorteil, da mehr Energie an das Piezoelement 5 übertragen werden kann. Eine Explosionsschutzwirkung kann erst erreicht werden, wenn genügend hochohmige Widerstände 8,8a eingesetzt werden. Es kommt also auf die Wahl der entsprechenden Bauteile und die angestrebte Anwendung an.

Im Folgenden soll die Explosionsschutzwirkung der in Fig. 2 gezeigten Schaltung anhand eines konkreten Beispiels gezeigt werden. Dazu werden für die einzelnen Bauteile konkrete Werte gewählt und zwei Energiebetrachtungen durchgeführt.

Die induktive Energie in einer Spule 7,7a,7b ist gegeben durch

$$E_{ind} = \frac{1}{2}LI^2.$$

Berücksichtigt man einen normgemäßen Sicherheitsfaktor von 1,5 für den Strom, ergibt sich bei einer Spule 7b mit L=1500μH und $E_{ind}$=20μJ (maximale erlaubte Energie in der Spule: $E_{ind}$=40μJ, Berücksichtigung eines Sicherheitsfaktors von 2) ein maximaler Strom von

$$I = \frac{\sqrt{\frac{2 \times 20\mu J}{1500\mu H}}}{1{,}5} = 0.163A$$

und entsprechend für den Widerstand bei U=10V (DC im Fehlerfall)

$$R = \frac{U}{I} = \frac{10V}{0.163A} = 61.4\Omega$$

Je nach Wahl des Vorwiderstandes 10 der Ausgangsstufe 4a innerhalb der Elektronikeinheit 4 sind also zusätzliche Widerstände 8,8a notwendig um eine ausreichende Strombegrenzung zu erreichen. Ein typischer Wert für den Vorwiderstand der Ausgangsstufe 4a beträgt $R_{10}$=50Ω, also müsste die Parallelschaltung $R_s$ der beiden Widerstände 8,8a mindestens so hoch gewählt werden, dass $R_s$=61.4Ω - 50Ω = 11.4Ω gilt. Weiterhin ist ein zweiter Widerstand 10a vorgesehen, der Innenwiderstand der Eingangsstufe 4b. Er ist notwendig für eine reflexionsfreie Übertragung des Antwortsignals und typischerweise wird für ihn der gleiche Wert wie der für den Vorwiderstand 10 gewählt. Bei einer Anpassung der Wechselspannung im Betrieb des Geräts sollte die Summe der Impedanzen 7,7a,7b und Widerstände 8,8a im Idealfall gleich dem Wert von $R_{10a}$=$R_{10}$ sein, während $R_{10}$ wiederum dem Wellenwiderstand des Triaxialkabels 6 entsprechen. Ebenfalls sollte bei der Arbeitsfrequenz die Phase der Schutzschaltung mit angeschlossenem Piezoelement 5 φ=0° betragen. Bei den Widerständen 8b,9 und 9a handelt es sich um die Gleichspannungswiderstände der Wicklungen.

Eine leichte Modifikation der Schaltung aus Fig. 2 besteht im Einfügen der Verbindung 11. In diesem Falle ergibt sich aufgrund der Parallelschaltung $R_s$=22.8Ω. Somit sorgt die zusätzliche Verbindung 11 für eine Erhöhung des Widerstandes $R_s$ und somit für eine Reduzierung des Stroms. Auf der anderen Seite fällt, wenn die Verbindung 11 weggelassen wird, weniger Spannung an den Widerständen 8,8a ab, so dass dem Piezoelement 5 mehr Energie zur Verfügung steht.

Ähnliches gilt für den sogenannten Schlagtest für einen mechanischen Schlag mit 7J am Piezoelement 5. Die Energie sollte ohne Induktivität normgemäß einen Wert von 50 μJ nicht überschreiten.

Für die kapazitive Energie gilt

$$E_{kap} = \frac{1}{2}CU^2.$$

Bei einem Piezoelement mit C=600pF, einer kapazitiven Energie von $E_{kap}$ = 20μJ sowie unter Berücksichtigung eines Sicherheitsfaktors von 2,5 für die Energie, ergibt sich für die Spannung am Piezoelement

$$U_{piezo} = \sqrt{\frac{2 \times 20\mu J}{600pF}} = 258V$$

Die maximale Spannung müsste somit bei einem mechanischen Schlag mit 7J unterhalb von $U_{piezo}$ = 258V liegen. Durch die Verwendung einer Spule 7b mit L=1500μH auf der Seite mit dem Piezoelement sowie den anderen beiden Spulen 8,8a wird diese Spannung nicht erreicht.

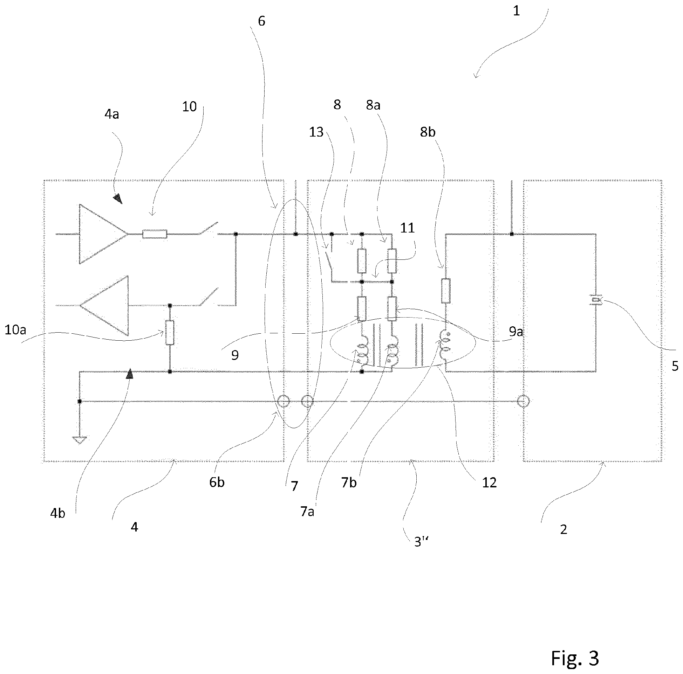

Ein zweites Beispiel für eine Explosionsschutzschaltung 3" ist in Fig. 3 gezeigt. Fig. 3 unterscheidet sich von Fig. 2 lediglich durch das Hinzufügen eines Schalters 13. Dieser ermöglicht die Überbrückung der mit den Spulen 7,7a in Reihe geschalteten Widerstände 8,8a, so dass die die Vorrichtung wahlweise mit oder ohne Explosionsschutzwirkung betrieben werden kann. Damit erübrigt sich die Entscheidung zwischen hoch- bzw. niederohmigen Widerständen 8,8a da diese jederzeit mittels der Schaltfunktion umgangen werden können.

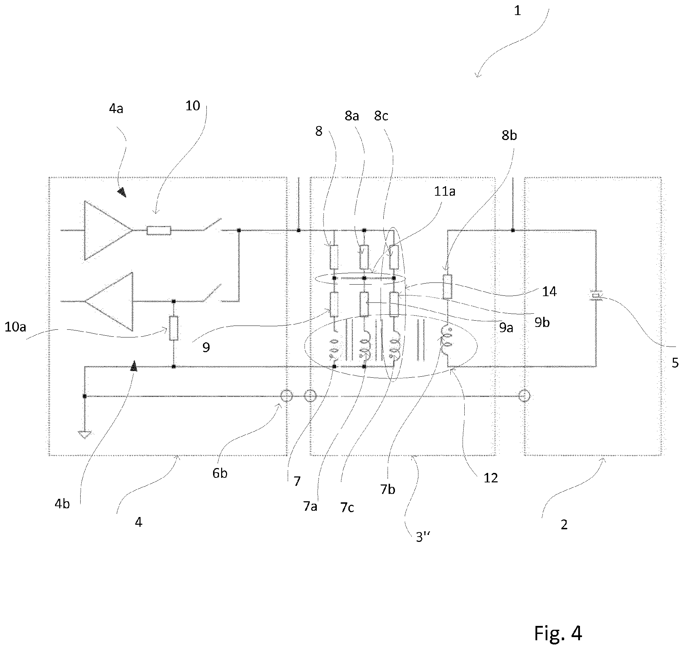

Ein letztes Beispiel ist in Fig. 4 dargestellt. Hierbei handelt es sich um eine Explosionsschutzschaltung 3‴ mit doppelter Ausfallsicherheit. Diese wird im vorliegenden Beispiel durch einen dritten Schaltungszweig 14 auf der dem Piezoelement 5 abgewandten Seite erreicht. In jedem der Schaltungszweige sind ein Widerstand 8,8a,8c in Reihe zu jeweils einer Spule 7,7a,7c geschaltet, sowie eine Verbindung der drei Schaltungszweige 11a hinzugefügt.

Eine alternative Maßnahme liegt darin, einen ausreichend großen Abstand zwischen dem das Piezoelement 5 beinhaltenden Schaltkreis und dem die drei Schaltzweige enthaltenen Schaltkreises zu gewährleisten. So können höhere Spannungen am Piezoelement mit geringem Risiko eines Überschlags im Betrieb verwendet werden.

Es versteht sich von selbst, dass die wesentlichen Funktionseinheiten der drei gezeigten Beispiele frei miteinander kombinierbar sind. Dies betrifft die Wahl der Art der Ausfallsicherheit, die Integration zusätzlicher Schalter wie die Schaltfunktion 13 in Fig. 3, oder auch die zusätzliche Verbindung 11,11a. In Bezug auf die einzelnen Bauteile müssen die Schwingkreise dann allerdings auf die jeweilige Anwendung abgestimmt werden.

Bei einer festen Anordnung der Explosionsschutzschaltung kann diese beispielsweise zusammen mit der das Piezoelement 5 beinhaltenden Schaltung in einem vergossenen Gehäuse angeordnet sein. Aber auch andere Anordnungen sind selbstverständlich denkbar.

**Bezugszeichenliste**

| | |
|---|---|
| 1 | Feldgerät |
| 2 | Sensoreinheit |
| 3 | Explosionsschutzschaltung |
| 4 | Elektronikeinheit |
| 4a, 4b | Eingangsstufe und Ausgangsstufe der Elektronikeinheit |
| 5 | Piezoelement |
| 6 | Triaxialkabel |
| 6a | Verbindung eines Leiters des Triaxialkabels mit dem metallischen Gehäuse |
| 7,7a,7b | Spulen |
| 8,8a-f | Widerstände |
| 9,9a,9b | Leitungswiderstände der Spulen |
| 10,10a | Vorwiderstände der Eingangsstufe und Ausgangsstufe |
| 11,11a | Verbindung |
| 12 | Transformator |
| 13 | Schaltfunktion bzw. Schalter |
| 14 | vierter Schaltzweig |

**Patentansprüche**

1. Vorrichtung zur Überwachung mindestens einer physikalischen oder chemischen Prozessgröße umfassend mindestens eine Sensoreinheit (2) und eine Elektronikeinheit (4) zur Signalerfassung, -auswertung und/oder -speisung,

   wobei die Sensoreinheit (2) mit Wechselstrom betrieben ist und/oder die Kommunikation zwischen der Elektronikeinheit (4) und der Sensoreinheit (2) mit Wechselstrom und/ oder Wechselspannung erfolgt,
   und mit einer Explosionsschutzschaltung (3) mit Eigensicherheit, welche eine Sicherheitsbarriere mit je mindestens einer Einheit zur Strombegrenzung und Spannungsbegrenzung umfasst, welche Explosionsschutzschaltung (3) zwischen der Sensoreinheit (2) und der Elektronikeinheit (4) angeordnet ist,
   wobei innerhalb der Explosionsschutzschaltung (3) eine Einheit eingerichtet zur Impedanzanpassung eingerichtet zur verlustfreien Signalübertragung zwischen Sensoreinheit und Elektronikeinheit vorgesehen ist, welche Einheit zur Impedanzanpassung zumindest einen Transformator (12) zur galvanischen Trennung von Sensoreinheit und Elektronikeinheit umfasst, **gekennzeichnet dadurch,**
   **dass** die Explosionsschutzschaltung (3) zumindest eine einfache Ausfallsicherheit aufweist, wobei eine Anzahl paralleler Zweige innerhalb der Explosionsschutzschaltung (3) die Ausfallsicherheit bestimmt, wobei eine einfache Ausfallsicherheit durch zwei parallele Zweige gegeben ist,
   wobei die Explosionsschutzschaltung (3) über mindestens zwei parallele Zweige verfügt,
   wobei je Zweig die Einheit zur Spannungsbegrenzung eine Spule (7,7a,7b,7c) umfasst,
   wobei je Zweig die Einheit zur Strombegrenzung einen zur Spule in Reihe geschalteten Widerstand (8,8a) umfasst.

2. Vorrichtung nach Anspruch 1,
   **gekennzeichnet dadurch,**
   **dass** die Einheit zur Impedanzanpassung so ausgestaltet ist, dass die Sensoreinheit (2) und die Elektronikeinheit (4) galvanisch voneinander getrennt sind.

3. Vorrichtung nach Anspruch 1 oder 2,
   **gekennzeichnet dadurch,**
   **dass** der Transformator (12) so ausgestaltet ist, insbesondere durch die Gewährleistung ausreichend großer Abstände und geeigneter Materialwahl wie Lacke und Isolationsfolien, dass er die galvanische Trennung gewährleistet.

4. Vorrichtung nach einem der vorhergehenden Ansprüche,
   **gekennzeichnet dadurch,**
   **dass** zumindest ein Bauteil in den Einheiten zur Strombegrenzung, Spannungsbegrenzung und Impedanzanpassung derart ausgelegt ist, dass es eine Doppelfunktion aufweist.

5. Vorrichtung nach einem der vorhergehenden Ansprüche,
   **gekennzeichnet dadurch,**
   **dass** die Sensoreinheit zumindest ein Piezoelement (5) aufweist.

6. Vorrichtung nach einem der vorhergehenden Ansprüche,
   **gekennzeichnet dadurch,**
   **dass** die Explosionsschutzschaltung (3) zwischen der Sensoreinheit (2) und der Elektronikeinheit (4) fest angeordnet ist.

7. Vorrichtung nach einem der Ansprüche 1 bis 6,
   **gekennzeichnet dadurch,**
   **dass** die Explosionsschutzschaltung (3) in einem separaten Steckadapter angeordnet ist, welcher Steckadapter nachrüstbar zwischen der Sensoreinheit (2) und der Elektronikeinheit (4) befestigt ist.

8. Vorrichtung nach einem der vorhergehenden Ansprüche,
   **gekennzeichnet dadurch,**

**dass** mindestens ein Bauteil, welches innerhalb der Einheiten zur Strom- und/oder Spannungsbegrenzung vorgesehen ist, mehrfach ausgeführt ist.

9. Vorrichtung nach einem der vorhergehenden Ansprüche,
**gekennzeichnet dadurch,**
**dass** die Explosionsschutzschaltung (3) eine Schaltfunktion (13) aufweist, und dass mit der Schaltfunktion (13) mindestens eine Einheit zur Gewährleistung der Eigensicherheit, insbesondere die Einheit zur Strombegrenzung, überbrückt, insbesondere kurzgeschlossen werden kann.

10. Vorrichtung nach Anspruch 9,
**gekennzeichnet dadurch,**
**dass** die Schaltfunktion (13) nur mit speziellem Werkzeug, insbesondere mit einem Schlüsselschalter, geändert werden kann, oder dass sie sich in einem Bereich der Vorrichtung befindet, welcher nur mittels speziellen Werkzeugs zugänglich wird.


**Claims**

1. Device for monitoring at least one physical or chemical process variable, comprising at least one sensor unit (2) and an electronics unit (4) for signal acquisition, evaluation and/or supply,

   wherein the sensor unit (2) is operated with alternating current and/or the communication between the electronics unit (4) and the sensor unit (2) takes place via alternating current and/or alternating voltage,
   and with an explosion protection circuit (3) with intrinsic safety, which comprises a safety barrier with at least one unit for current limitation and voltage limitation,
   wherein the explosion protection circuit (3) is arranged between the sensor unit (2) and the electronics unit (4),
   wherein within the explosion protection circuit (3) a unit for impedance matching is provided for lossless signal transmission between the sensor unit and the electronics unit, which unit for impedance matching comprises at least one transformer (12) for galvanic isolation between the sensor unit and the electronics unit,
   **characterized in that**
   the explosion protection circuit (3) has at least simple fault tolerance,
   wherein a number of parallel branches within the explosion protection circuit (3) determines the fault tolerance, with simple fault tolerance being provided by two parallel branches,
   wherein the explosion protection circuit (3) has at least two parallel branches, wherein each branch comprises a coil (7, 7a, 7b, 7c) as the voltage limiting unit,
   and wherein each branch comprises a resistor (8, 8a) connected in series with the coil as the current limiting unit.

2. Device according to claim 1,
**characterized in that**
the impedance matching unit is designed such that the sensor unit (2) and the electronics unit (4) are galvanically isolated from each other.

3. Device according to claim 1 or 2,
**characterized in that**
the transformer (12) is designed, in particular by ensuring sufficiently large distances and suitable material selection such as varnishes and insulation films, to ensure galvanic isolation.

4. Device according to any of the preceding claims,
**characterized in that**
at least one component in the units for current limitation, voltage limitation and impedance matching is designed to have a dual function.

5. Device according to any of the preceding claims,
**characterized in that**
the sensor unit comprises at least one piezo element (5).

6. Device according to any of the preceding claims,
**characterized in that**
the explosion protection circuit (3) is permanently arranged between the sensor unit (2) and the electronics unit (4).

7. Device according to any of claims 1 to 6,
**characterized in that**
the explosion protection circuit (3) is arranged in a separate plug-in adapter, which is retrofittable and mounted between the sensor unit (2) and the electronics unit (4).

8. Device according to any of the preceding claims,
**characterized in that**
at least one component provided within the units for current and/or voltage limitation is implemented in multiple instances.

9. Device according to any of the preceding claims,
**characterized in that**
the explosion protection circuit (3) comprises a switching function (13), and that with the switching function (13) at least one unit for ensuring intrinsic safety, in particular the current limiting unit, can be bypassed, in particular short-circuited.

10. Device according to claim 9,

**characterized in that**
the switching function (13) can only be changed with a special tool, in particular with a key switch, or that it is located in a part of the device that is only accessible using a special tool.

**Revendications**

1. Dispositif de surveillance d'au moins une grandeur physique ou chimique de procédé, comprenant au moins une unité capteur (2) et une unité électronique (4) pour la détection, l'évaluation et/ou l'alimentation du signal,

   dans lequel l'unité capteur (2) est alimentée en courant alternatif et/ou la communication entre l'unité électronique (4) et l'unité capteur (2) se fait par courant et/ou tension alternatifs, et comprenant un circuit de protection contre les explosions (3) à sécurité intrinsèque, lequel comprend une barrière de sécurité avec au moins une unité de limitation de courant et de tension,
   le circuit de protection contre les explosions (3) étant disposé entre l'unité capteur (2) et l'unité électronique (4),
   dans lequel une unité d'adaptation d'impédance est prévue à l'intérieur du circuit de protection contre les explosions (3) pour une transmission de signal sans perte entre l'unité capteur et l'unité électronique, ladite unité d'adaptation d'impédance comprenant au moins un transformateur (12) pour l'isolation galvanique entre l'unité capteur et l'unité électronique,
   **caractérisé en ce que**
   le circuit de protection contre les explosions (3) présente au moins une sécurité de défaillance simple,
   le nombre de branches parallèles dans le circuit de protection contre les explosions (3) déterminant la sécurité de défaillance, une sécurité de défaillance simple étant assurée par deux branches parallèles,
   le circuit de protection contre les explosions (3) comportant au moins deux branches parallèles, chaque branche comprenant une bobine (7, 7a, 7b, 7c) comme unité de limitation de tension, et chaque branche comprenant une résistance (8, 8a) connectée en série avec la bobine comme unité de limitation de courant.

2. Dispositif selon la revendication 1,
   **caractérisé en ce que**
   l'unité d'adaptation d'impédance est conçue de manière à ce que l'unité capteur (2) et l'unité électronique (4) soient isolées galvaniquement l'une de l'autre.

3. Dispositif selon la revendication 1 ou 2,
   **caractérisé en ce que**
   le transformateur (12) est conçu, notamment par le respect de distances suffisantes et le choix de matériaux appropriés tels que des vernis et des films isolants, pour garantir l'isolation galvanique.

4. Dispositif selon l'une des revendications précédentes,
   **caractérisé en ce que**
   au moins un composant des unités de limitation de courant, de limitation de tension et d'adaptation d'impédance est conçu pour remplir une double fonction.

5. Dispositif selon l'une des revendications précédentes,
   **caractérisé en ce que**
   l'unité capteur comprend au moins un élément piézoélectrique (5).

6. Dispositif selon l'une des revendications précédentes,
   **caractérisé en ce que**
   le circuit de protection contre les explosions (3) est fixé de manière permanente entre l'unité capteur (2) et l'unité électronique (4).

7. Dispositif selon l'une des revendications 1 à 6,
   **caractérisé en ce que**
   le circuit de protection contre les explosions (3) est disposé dans un adaptateur enfichable séparé, lequel est monté de manière rétroactive entre l'unité capteur (2) et l'unité électronique (4).

8. Dispositif selon l'une des revendications précédentes,
   **caractérisé en ce que**
   au moins un composant prévu dans les unités de limitation de courant et/ou de tension est réalisé en plusieurs exemplaires.

9. Dispositif selon l'une des revendications précédentes,
   **caractérisé en ce que**
   le circuit de protection contre les explosions (3) comprend une fonction de commutation (13), et que cette fonction permet de court-circuiter ou de contourner au moins une unité assurant la sécurité intrinsèque, notamment l'unité de limitation de courant.

10. Dispositif selon la revendication 9,
    **caractérisé en ce que**
    la fonction de commutation (13) ne peut être modifiée qu'à l'aide d'un outil spécial, notamment un commutateur à clé, ou qu'elle est située dans une zone du dispositif accessible uniquement à l'aide d'un outil spécial.

| Sensoreinheit | Explosionsschutz-<br>schaltung mit<br>Impedanzanpassung | Elektronikeinheit |

1

2 3 4

Fig. 1

Fig. 2

Fig. 3

Fig. 4

**IN DER BESCHREIBUNG AUFGEFÜHRTE DOKUMENTE**

**In der Beschreibung aufgeführte Patentdokumente**

- EP 0882955 A1
- DE 29809853 U1
- WO 2004098014 A1
- US 4708022 A1
- EP 0817149 A1